# EUROPÄISCHE PATENTSCHRIFT

(11) **EP 0 499 707 B1**
(45) Veröffentlichungstag und Bekanntmachung des Hinweises auf die Patenterteilung: **03.04.1996**
(21) Anmeldenummer: 91121203.3
(22) Anmeldetag: 11.12.1991
(51) Int. Cl.: H01L 25/07, H01L 23/48

(54) **Abschaltbares Hochleistungs-Halbleiterbauelement**
Gate turn-off semiconductor power component
Composant semi-conducteur de puissance à commande d'extinction

(30) Priorität: 22.02.1991 CH 538/91
(43) Veröffentlichungstag der Anmeldung: 26.08.1992
(73) Patentinhaber: ASEA BROWN BOVERI AG, CH-5401 Baden (CH)
(72) Erfinder: Gobrecht, Jens, Dr., CH-5412 Gebenstorf (CH); Stockmeier, Thomas, Dr., CH-5303 Würenlingen (CH)

(56) Entgegenhaltungen:
- EP-A- 0 064 383
- EP-A- 0 265 833
- EP-A- 0 347 613
- EP-A- 0 355 359
- FR-A- 2 620 862
- GB-A- 2 135 824
- US-A- 4 313 128

## Beschreibung

### TECHNISCHES GEBIET

Die vorliegende Erfindung bezieht sich auf das Gebiet der Leistungselektronik. Sie betrifft insbesondere ein abschaltbares Hochleistungs-Halbleiterbauelement für einen maximalen Abschaltstrom grösser 100 A nach dem Oberbegriff des ersten Anspruchs.

### STAND DER TECHNIK

Ein solches Bauelement ist z.B. aus der Druckschrift EP-A1-0 265 833 in Form eines MOSFET bekannt.

Aufgrund der schaltungsseitig stetig steigenden Anforderungen werden zukünftige Leistungshalbleiter-Bauelemente auch im Hochleistungsbereich feinstrukturiert sein, d.h. Strukturen im µm-Bereich aufweisen. Dabei kommen sowohl rein bipolare wie auch gemischte Bipolar- und MOS-Technologien (BiMOS) für die Realisierung in Betracht. Ein Beispiel für den mittleren Leistungsbereich, wo sich diese Strukturen bereits durchgesetzt haben, ist der IGBT (Insulated Gate Bipolar Transistor).

Es ist nun einerseits allgemein bekannt, dass mit zunehmender Strombelastung auch die aktiven Flächen und damit die Chipgrösse derartiger Bauelemente steigen. So werden im Hochleistungsbereich Ströme (von einigen 100 A bis zu einigen 1000 A) gesteuert oder geschaltet, die sich nur mit Chipflächen beherrschen lassen, welche wesentlich grösser sind als 1 cm.
mit Chipflächen beherrschen lassen, welche wesentlich grösser sind als 1 cm.

Andererseits treten bei der Herstellung von Halbleiter-Bauelementen unvermeidlich Defekte auf, welche die sog. Chipausbeute ("yield") begrenzen. Die Dichte dieser Defekte ist dabei im wesentlichen durch die zur Verfügung stehende Reinraumklasse und die Zahl der Prozessschritte gegeben. Naturgemäss nimmt die Ausbeute mit zunehmender Chipfläche und auch mit zunehmender Miniaturisierung der Bauelement-Strukturen ab. In der Praxis geht man derzeit davon aus, dass sich feinstrukturierte Bauelemente mit Chipflächen wesentlich grösser als 1 cm nicht wirtschaftlich herstellen lassen. Dies äussert sich z. B. auch in den Chip-Preisen: 5 MOSFETs zu je 10 A sind zusammen billiger als 1 Chip zu 50 A.

Ein solcher Multichip MOSFET ist beispielsweise aus der Europäischen Patentanmeldung EP-A1-0 265 833 bekannt. Die Halbleiterchips sind dabei auf einem gemeinsamen Substrat aufgebracht und werden mittels Bonddrähten verbunden. Die ganze Anordnung ist in einem gemeinsamen Gehäuse untergebracht.

Für die erwähnten Hochleistungs-Bauelemente werden deshalb intensiv sog. "Reparaturtechniken" untersucht, die es erlauben sollen, die Defekte zu eliminieren oder zu passivieren, und so auf grossen Flächen doch akzeptable Ausbeuten zu erzielen. So ist in der eingangs genannten Druckschrift vorgeschlagen worden, bei einem grossflächigen Halbleiter-Bauelement (GTO oder Leistungstransistor), welches mehrere 1000 Einzelelemente umfasst, die Einzelelemente in Gruppen (z.B. zu je 100) zusammenzufassen und pro Gruppe gemeinsam zu kontaktieren. Auf diese Weise können defekte Einzelelemente innerhalb einer Gruppe leichter detektiert und unschädlich gemacht werden.

Derartige Reparaturkonzepte haben jedoch folgende Nachteile:
- die Stillegung bestimmter Einzelelemente oder ganzer Teilflächen führt zu einer inhomogenen Stromverteilung über der Bauelementfläche, die möglicherweise die elektrische Funktion, insbesondere das Abschaltvermögen bei Thyristoren, beeinträchtigen kann; und
- die Reparatur selbst (einschl. der Identifizierung der defekten Einzelelemente) erfordert einen erheblichen messtechnischen und Zeitaufwand.

### DARSTELLUNG DER ERFINDUNG

Es ist daher Aufgabe der Erfindung, ein Hochleistungs-Halbleiterbauelement zu schaffen, welches bei einfacher Herstellung mit hoher Ausbeute produziert werden kann, und ohne Reparaturtechniken auskommt.

Die Aufgabe wird bei einem Bauelement der eingangs genannten Art durch die Merkmale des ersten Anspruchs gelöst.

Der Kern der Erfindung besteht also darin, anstelle eines einzelnen Chips mit grosser Fläche eine Vielzahl von kleinflächigen Chips zu einem Bauelement zusammenzufassen. Die kleinflächigen Chips (Fläche kleiner 1 cm) lassen sich dabei mit akzeptabler Ausbeute herstellen, einzeln testen (Autoprober) und bei Funktionstüchtigkeit mosaikartig und hybrid zu einem einzigen Hochleistungs-Bauelement integrieren. Die einzelnen Chips sind in einem gemeinsame Gehäuse untergebracht. Das Gehäuse weist einen mit Kontaktstempeln versehenen scheibenförmigen Kathodenkontakt und einen Anodenkontakt auf, welche über Flansche mit dem Gehäuse verbunden sind und dieses beidseitig abschliessen. Als Gateelektrode ist eine Gateplatte vorgesehen, durch welche die Kontaktstempel hindurchgeführt werden können und welche die Zuleitungen für die Steuerung der Halbleiterchips trägt.

Mit einem derartigen Gehäuse und Anordnung der Halbleiterchips kann ein handelsübliches "press-pack" oder "hockey-puck" Gehäuse verwendet werden. Beispielweise wird ein solches Gehäuse im Dokument US-A-4 313 128 beschrieben.

Es wird dabei vorausgesetzt, dass die in Frage kommenden feinstrukturierten Bauelemente einfach parallel geschaltet werden können. Für einige dieser Bauelemente wie Leistungs-MOSFETs, FCThs und IGBTs ist die Richtigkeit dieser Voraussetzung in der Praxis bereits bestätigt worden.

Die tatsächliche Flächengrösse der Chips wird aus dem Optimum zwischen der für die jeweilige Fertigung gültigen Defektdichte und der für den Randabschluss zusätzlich notwendigen Halbleiterfläche (abhängig von der Blockierspannung) berechnet. Unter den derzeit üblichen Bedingungen dürfte dieser Wert zwischen 0,2 und 1 cm liegen, bei sehr guter Reinraumklasse vielleicht auch etwas darüber.

Die erfindungsgemässe Lösung weist neben den bereits aufgeführten weitere wesentliche Vorteile auf:
- im Sinne eines modularen Aufbaus kann der gesamte Strombereich durch ein einziges Design (1 Maskensatz) abgedeckt werden;
- die für die meisten Umrichter vorteilhaft einsetzbaren rückwärtsleitenden Bauelemente lassen sich durch entsprechende Kombination von Thyristorchips und Diodenchips besonders einfach realisieren, zumal die Dioden- und Thristorelemente unabhängig voneinander optimiert werden können;
- die einzelnen Chips mit ihrer Fläche kleiner 1 cm können - im Gegensatz zu grossflächigen Bauelementen - vorteilhaft mit der heute für ICs üblichen Stepper-Technologie hergestellt werden; und
- die Montage der einzelnen Chips kann in bewährter "die-bond"- oder Löttechnik erfolgen und ist sehr leicht automatisierbar.

Besondere Vorteile bringt die Erfindung, wenn der maximale Abschaltstrom des Bauelements grösser 1000 A ist und seine aktive Fläche grösser 10 cm ist.

### KURZE BESCHREIBUNG DER ZEICHNUNG

Die Erfindung soll nachfolgend anhand von Ausführungsbeispielen im Zusammenhang mit der Zeichnung näher erläutert werden. Es zeigen
- Fig. 1: im Querschnitt eine bevorzugte Ausführungsform eines Bauelements nach der Erfindung;
- Fig. 2: im vergrösserten Ausschnitt Anordnung und Anschluss der einzelnen Halbleiterchips bei einem Bauelement gemäss Fig. 1;
- Fig. 3: in Draufsicht eine mögliche Ausgestaltung der Gateplatte aus Fig. 1 und 2;
- Fig. 4: in Draufsicht die Anordnung von Thyristor- und Halbleiterchips auf dem Substrat für die Ausführungsform eines rückwärtsleitenden Thyristors gemäss Fig. 1 und 2; und
- Fig. 5: eine weitere bevorzugte Ausführungsform eines Bauelements nach der Erfindung mit Sandwich-Aufbau für den einzelnen Halbleiterchip und kathoden- und anodenseitigen Kontaktstempeln.

### WEGE ZUR AUSFÜHRUNG DER ERFINDUNG

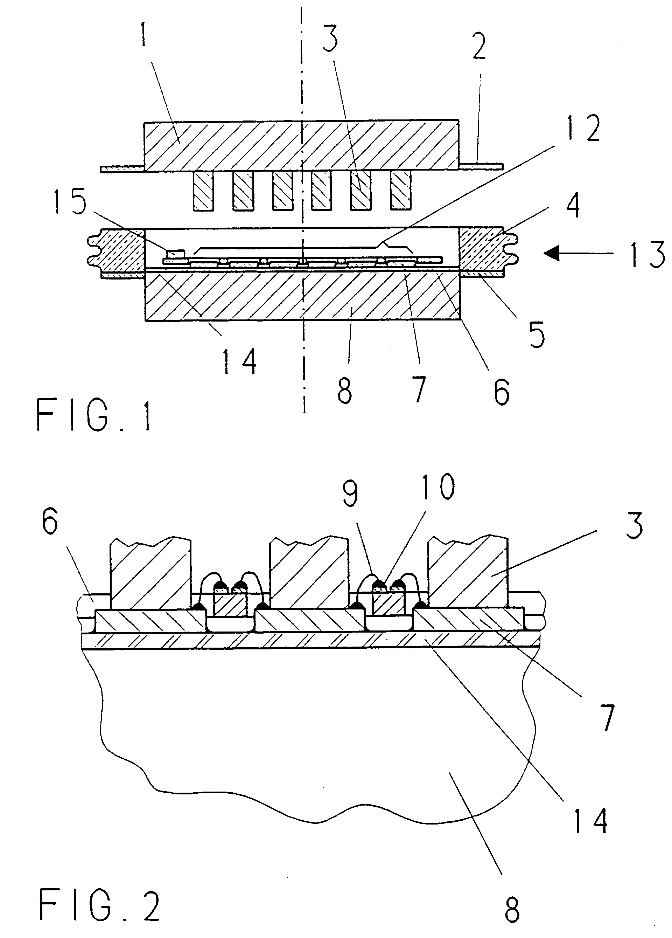

In Fig. 1 ist im Querschnitt ein bevorzugtes Ausführungsbeispiel für ein Hochleistungs-Halbleiterbauelement nach der Erfindung in der Gesamtansicht dargestellt. Zentraler Bestandteil dieses Bauelements ist eine Halbleiteranordnung 12 mit einer Vielzahl von einzelnen, getrennt nebeneinander angeordneten Halbleiterchips 7, die in einem gemeinsamen Gehäuse 13 untergebracht und elektrisch parallelgeschaltet sind. Die gesamte, für hohe Ströme benötigte, aktive Halbleiterfläche wird auf diese Weise aus einer Vielzahl von Einzelflächen zusammengesetzt.

Das Gehäuse 13 hat vorzugsweise einen aus dem Stand der Technik bekannten Aufbau (Metall-Keramik oder Metall-Kunststoff-Gehäuse in "Hockey-Puck"-Form). Es besteht zunächst aus einem ringförmigen (oder quadratischen oder rechteckigen oder sonstwie geschlossenen) Isoliergehäuse 4 aus Keramik oder Kunststoff, das z.B. - wie in Fig. 1 gezeigt - für hohe Blockierspannungen auf der Aussenseite in an sich bekannter Weise rippenartig ausgestaltet sein kann. Das Isoliergehäuse 4 wird auf der Oberseite durch einen massiven scheibenförmigen Kathodenkontakt 1, auf der Unterseite durch einen entsprechenden Anodenkontakt 8 abgeschlossen, wobei die stoffschlüssige Verbindung über geeignete Flansche 2 und 5 erfolgt (in Fig. 1 ist der Kathodenkontakt 1 der besseren Uebersicht wegen im abgenommenen Zustand dargestellt). Kathodenkontakt 1 und Anodenkontakt 8 sind aus einem elektrisch und thermisch gut leitenden Material, beispielsweise Cu, hergestellt.

Die Halbleiterchips 7 sind beidseitig (auf der Ober- und Unterseite) kontaktiert. Sie sind dazu auf ein scheibenförmiges, leitendes Substrat 14 aufgelötet oder aufgebondet, welches in seiner thermischen Ausdehnung an das Halbleitermaterial angepasst ist und z.B. aus Mo, Cu oder einer Mo-Cu-Verbindung besteht. Das Substrat 14 liegt auf dem Anodenkontakt 8 auf und wird gegen diesen gepresst. Zu diesem Zweck sind auf der gegenüberliegenden Innenseite des Kathodenkontakts 1, direkt über jedem der Halbleiterchips 7, einzelne Kontaktstempel 3 angeordnet, die nach dem Zusammenbau auf die Halbleiterchips 7 drücken und diese gleichzeitig auf Ihrer Oberseite kontaktieren. Die Kontaktstempel 3 können aus demselben Material bestehen wie der Kathodenkontakt 1 und z.B. durch Anbringen entsprechender Nute oder Schlitze aus dem Vollmaterial des Kathodenkontakts 1 herausgearbeitet worden sein. In einer analogen, aber drucklosen Gehäuseform können die Kontaktstempel 3 aber auch auf die Oberflächen der Halbleiterchips 7 gelötet werden.

Durch das gemeinsame Substrat 14 und die am Kathodenkontakt 1 direkt angebrachten Kontaktstempel 3 werden die Halbleiterchips 7 in ihrer Gesamtheit elektrisch parallelgeschaltet und elektrisch und thermisch an das Gehäuse 13 angekoppelt. Der zu steuernde Strom fliesst hierbei über den Kathodenkontakt 1 und den Anodenkontakt 8.

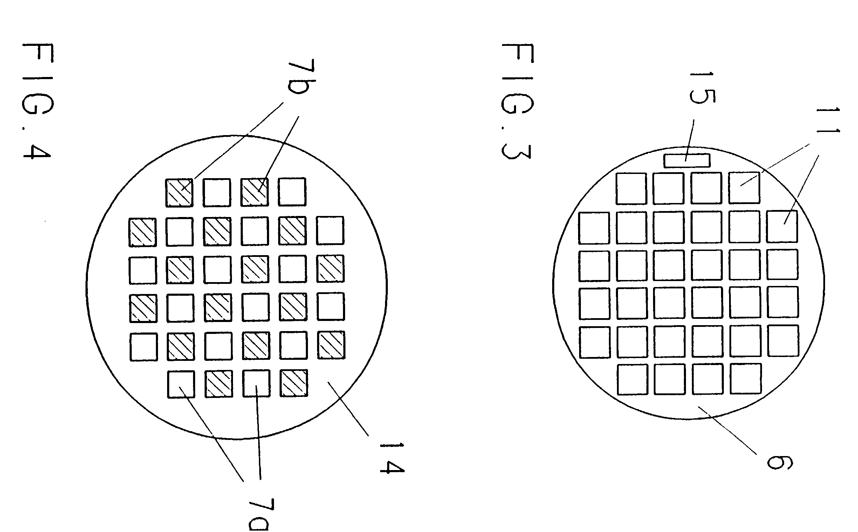

Für die Ansteuerung der einzelnen Halbleiterchips 7 ist eine separate, scheibenförmige Gateplatte 6 vorgesehen, die parallel zu und etwas oberhalb von dem Substrat 14 angeordnet ist und die Halbleiterchips 7 umgibt. Die Gateplatte 6 weist dazu eine Vielzahl von Durchgangslöchern 11 auf (Fig. 3), die in Anordnung und Anzahl den Halbleiterchips 7 entsprechen und Platz für die Kontaktstempel 3 lassen. Die Gateplatte 6 ist beispielsweise eine gedruckte Schaltungsplatine mit Leiterbahnen 10 (Fig. 2), welche die Ansteuersignale für die Halbleiterchips 7 leiten und durch Bonddrähte 9 mit den Gateanschlüssen der einzelnen Halbleiterchips 7 verbunden sind. Der Anschluss des Bauelement-Gates muss jedoch nicht - wie in Fig. 2 dargestellt - unbedingt durch Bonden jedes einzelnen Halbleiterchips 7 erfolgen, sondern die Gateplatte 6 kann auch kleine Kontaktzungen aufweisen, die dann auf entsprechende Bumps auf den Halbleiterchips 7 drücken. Derartige Montagetechniken sind z.B. aus der IC-Technologie bekannt.

Die Gateplatte 6 kann darüberhinaus vorteilhafterweise auf ihren freien Flächen ein oder mehrere Bauelemente 15 (z.B. Treibertransistoren und/oder passive Bauelemente) tragen, die der Ansteuerung oder dem Schutz der einzelnen Halbleiterchips 7 dienen (Fig. 1 und 3).

Auf die Art und interne Struktur der Halbleiterchips 7 selbst ist bei den bisherigen Erläuterungen nicht näher eingegangen worden. Sofern das Bauelement insgesamt einen MCT, IGBT, GTO oder MOSFET darstellt, ist die interne Struktur aller Halbleiterchips 7 entsprechend die Struktur eines MCT, IGBT, GTO oder MOSFET.

Anders ist die Situation, wenn beispielsweise das Bauelement die Funktion eines rückwärtsleitenden Thyristors erfüllen soll. In diesem Fall ist die Menge der Halbleiterchips 7 in zwei Teilmengen unterteilt (Fig. 4); die eine der beiden Teilmengen besteht aus Thyristorchips 7a mit einer internen Thyristorstruktur, und die andere der beiden Teilmengen besteht aus Diodenchips 7b mit einer internen Diodenstruktur. Innerhalb der Halbleiteranordnung 12 sind dann (wie in Fig. 4 dargestellt) die Thyristorchips 7a und die Diodenchips 7b abwechselnd nebeneinander angeordnet und antiparallel zueinander geschaltet, so dass sie insgesamt einen rückwärtsleitenden Thyristor bilden.

Als Beispiel sei dazu auf einen rückwärtsleitenden MOS-gesteuerten Thyristor (MCT) mit einem maximalen Abschaltstrom von 2000 A verwiesen: Bei einer angenommenen optimalen Grösse der Halbleiterchips 7 von 0,5 cm (entspricht etwa 50 A abschaltbarem Strom) werden für dieses Bauelement 40 Thyristorchips 7a vom MCT-Typ und z.B. 20 gleich grosse Diodenchips 7b benötigt und in der in Fig. 4 dargestellten Weise miteinander kombiniert.

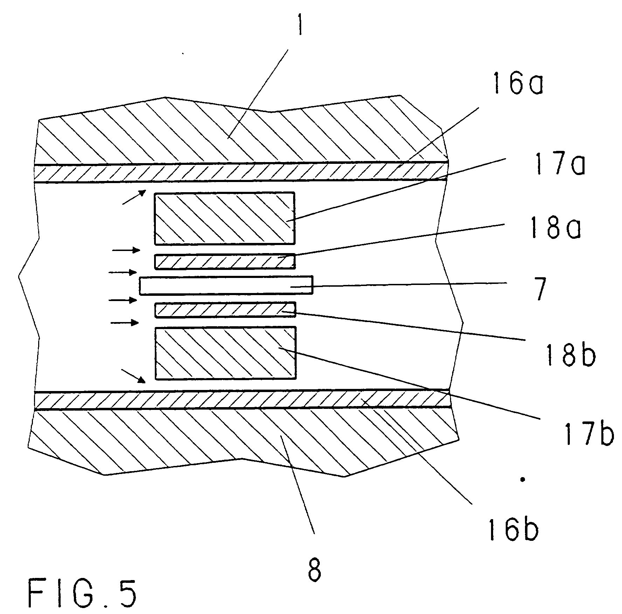

An dieser Stelle sei angemerkt, dass Kontaktstempel zur Kontaktierung der Halbleiterchips 7 nicht nur auf der Kathodenseite vorgesehen werden können (wie in Fig. 1 und 2 gezeigt), sondern auch auf der Anodenseite (siehe dazu beispielsweise auch Fig. 5). Das ist insbesondere bei dem gerade beschriebenen rückwärtsleitenden Bauelement wichtig, da bei den antiparallelen Dioden die Hochspannung an der Anodenseite anliegt und aus diesem Grund ein genügend grosser Abstand zur Unterlage vorhanden sein muss, um Ueberschläge zu vermeiden.

In Fig. 5 ist schliesslich in einer Explosions-Darstellung ausschnittweise ein weiteres bevorzugtes Ausführungsbeispiel eines Bauelements nach der Erfindung wiedergegeben. Die einzelnen Halbleiterchips 7 werden in diesem Fall mit oberen und unteren Mo-Scheiben 18a bzw. 18b und oberen und unteren Kontaktstempeln 17a bzw. 17b (aus z.B. Cu) durch Löten zu einer Sandwich-artigen Struktur zusammengefügt. Die einzelnen Sandwiches werden dann zwischen eine obere und eine untere Mo-Platte 16a bzw. 16b gelötet, die schliesslich in das Gehäuse eingesetzt werden. Die Pfeile in der Fig. 5 deuten dabei die Lage der Lot-Zwischenschichten an, die für den Zusammenhalt der Struktur notwendig sind. Für den Gateanschluss kann auch in diesem Fall wieder eine Gateplatte vorgesehen werden, die der Uebersichtlichkeit wegen in Fig. 5 nicht eingezeichnet ist.

## Patentansprüche

1. Abschaltbares Hochleistungs-Halbleiterbauelement für einen maximalen Abschaltstrom grösser 100 A, umfassend
(a) eine Halbleiteranordnung (12) mit einer aktiven Halbleiterfläche grösser 1 cm;
(b) innerhalb der Halbleiteranordnung (12) eine Feinstruktur aus einer Vielzahl von parallelgeschalteten Einzelelementen, wobei die Einzelelemente zu Gruppen zusammengefasst sind und die Halbleiteranordnung (12) aus einer Vielzahl von einzelnen, gleichartigen und parallelgeschalteten Halbleiterchips (7), welche eine aktive Fläche von kleiner oder ungefähr gleich 1 cm haben und jeweils eine von den oben definierten Gruppen von Einzelelementen umfassen, besteht;
(c) ein gemeinsames, elektrische leitendes Substrat (14), auf welches die Halbleiterchips (7) in einem gemeinsamen Gehäuse (13) untergebracht sind
dadurch gekennzeichnet, dass
(d) das gemeinsame Gehäuse (13) ein Isoliergehäuse (4) sowie einen scheibenförmigen Kathodenkontakt (1) und einen scheibenförmigen Anodenkontakt (8) umfasst, wobei der Kathodenkontakt (1) und der Anodenkontakt (8) jeweils über Flansche (2,5) mit dem Isoliergehäuse (4) verbunden sind und das Gehäuse (13) zu beiden Seiten hin abschliessen;
(e) die Halbleiterchips (7) von einer gemeinsamen, isoliert aufgebauten und parallel zum Substrat (14) liegenden Gateplatte (6) umgeben sind, welche Gateplatte (6) die Zuleitungen für die Steuerung der Halbleiterchips (7) trägt;
(f) der Kathodenkontakt (1) auf seiner Innenseite mit Kontaktstempeln (3) für jeden der Halbleiterchips (7) ausgerüstet ist; und
(g) die Kontaktstempel (3) durch Durchgangslöcher (11) in der Gateplatte (6) hindurch auf die Halbleiterchips (7) drücken und diese kontaktieren.

2. Bauelement nach Anspruch 1, dadurch gekennzeichnet, dass der maximale Abschaltstrom grösser 1000 A ist die aktive Fläche grösser 10 cm ist.

3. Bauelement nach Anspruch 1, dadurch gekennzeichnet, dass zumindest ein Teil der Halbleiterchips (7) jeweils die innere Struktur eines Bauelements aus der Gruppe der MCTs, IGBTs, GTOs und MOSFETs aufweisen.

4. Bauelement nach Anspruch 3, dadurch gekennzeichnet, dass
(a) die Menge der Halbleiterchips (7) in zwei Teilmengen unterteilt ist;
(b) die eine der beiden Teilmengen Thyristorchips (7a) mit einer internen Thyristorstruktur und die andere der beiden Teilmengen Diodenchips (7b) mit einer internen Diodenstruktur umfasst; und
(c) innerhalb der Halbleiteranordnung (12) die Thyristorchips (7a) und die Diodenchips (7b) abwechselnd nebeneinander angeordnet und antiparallel zueinander geschaltet sind, und einen rückwärtsleitenden Thyristor bilden.

5. Bauelement nach Anspruch 1, dadurch gekennzeichnet, dass
(a) das Substrat (14) eine Scheibe aus einem der Metalle Mo, Cu oder einer Cu-Mo-Verbindung ist;
(b) die Halbleiterchips (7) auf das Substrat (14) aufgelötet oder aufgebondet sind; und
(c) die Gateplatte (6) als Schaltungsplatine ausgebildet ist, mit welcher die Halbleiterchips (7) durch Bonddrähte (9) verbunden sind.

6. Bauelement nach Anspruch 5, dadurch gekennzeichnet, dass die Gateplatte (6) zusätzlich wenigstens ein Bauelement (15) trägt, welches zur Ansteuerung oder zum Schutz der Halbleiterchips (7) vorgesehen ist.

7. Bauelement nach Anspruch 1, dadurch gekennzeichnet, dass
(a) der Kathodenkontakt (1) auf seiner Innenseite mit einer Mehrzahl von oberen Kontaktstempeln (17a) ausgerüstet ist;
(b) der Anodenkontakt (8) auf seiner Innenseite mit einer Mehrzahl von unteren Kontaktstempeln (17b) ausgerüstet ist; und
(c) jedes Halbleiterchip (7) jeweils zwischen einem oberen und unteren Kontaktstempel (17a bzw. 17b) angeordnet ist.

## Claims

1. Controlled-turn-off high-power semiconductor component for a maximum turn-off current of more than 100 A, comprising
(a) a semiconductor device (12) having an active semiconductor area which is substantially greater than 1 cm;
(b) a fine structure composed of a multiplicity of parallel-connected individual elements inside the semiconductor device (12), the individual elements being combined in groups and the semiconductor device (12) being composed of a multiplicity of individual, similar and parallel-connected semiconductor chips (7) which have an active area which is less than or approximately equal to 1 cm and each comprise one of the groups of individual elements defined above;
(c) a common, electrically conducting substrate (14) on which the semiconductor chips (7) are accommodated in a common housing (13)
characterized in that
(d) the common housing (13) comprises an insulating housing (4) and a disc-type cathode contact (1) and a disc-type anode contact (8), the cathode contact (1) and the anode contact (8) each being joined to the insulating housing (4) by means of flanges (2, 5) and sealing the housing (13) on both sides;
(e) the semiconductor chips (7) are surrounded by a common gate plate (6) which is of insulated construction and is parallel to the substrate (14), which gate plate (6) carries the leads for controlling the semiconductor chips (7);
(f) the cathode contact (1) is provided on its inner side with contact posts (3) for each of the semiconductor chips (7); and
(g) the contact posts (3) press on the semiconductor chips (7) through passage holes (11) in the gate plate (6) and make contact to the former.

2. Component according to Claim 1, characterized in that the maximum turn-off current is greater than 1000 A the active area is greater than 10 cm.

3. Component according to Claim 1, characterized in that at least some of the semiconductor chips (7) have in each case the internal structure of a component from the group comprising the MCTs, IGBTs, GTOs and MOSFETs.

4. Component according to Claim 3, characterized in that
(a) the semiconductor chip (7) population is subdivided into two subpopulations;
(b) one of the two subpopulations comprises thyristor chips (7a) having an internal thyristor structure, and the other of the two subpopulations comprises diode chips (7b) having an internal diode structure; and
(c) inside the semiconductor device (12) the thyristor chips (7a) and the diode chips (7b) are alternately arranged alongside one another and connected antiparallel to one another, and form a reverse-conducting thyristor.

5. Component according to Claim 1, characterized in that
(a) the substrate (14) is a disc made of one of the metals Mo, Cu or of a Cu-Mo compound;
(b) the semiconductor chips (7) are soldered or bonded onto the substrate (14); and
(c) the gate plate (6) is constructed as a circuit board to which the semiconductor chips (7) are connected by bonding wires (9).

6. Component according to Claim 5, characterized in that the gate plate (6) additionally carries at least one component (15) which is provided to trigger or to protect the semiconductor chips (7).

7. Component according to Claim 1, characterized in that
(a) the cathode contact (1) is provided on its inner side with a plurality of upper contact posts (17a);
(b) the anode contact (8) is provided on its inner side with a plurality of lower contact posts (17b); and
(c) every semiconductor chip (7) is arranged in each case between an upper and a lower contact post (17a and 17b respectively).

## Revendications

1. Composant semi-conducteur de puissance élevée à commande d'extinction, pour un courant d'extinction maximum supérieur à 100 A, comportant
(a) une disposition de semi-conducteur (12) avec une surface active de semi-conducteur supérieure à 1 cm ;
(b) à l'intérieur de la disposition de semi-conducteur (12), une structure fine constituée d'une multiplicité d'éléments individuels branchés en parallèle, les éléments individuels étant réunis en groupes et la disposition de semi-conducteur (12) étant constituée d'une multiplicité de puces semi-conductrices (7) individuelles du même type et branchées en parallèle, qui ont une surface active inférieure ou environ égale à 1 cm, et qui comportent respectivement un des groupes d'éléments individuels du type défini ci-dessus ;
(c) un substrat (14) commun, électriquement conducteur, sur lequel les puces semi-conductrices (7) sont abritées dans un boîtier commun (13)
caractérisé en ce que
(d) le boîtier commun (13) comporte un boîtier isolant (4) ainsi qu'un contact de cathode (1) en forme de disque et un contact d'anode (8) en forme de disque, le contact de cathode (1) et le contact d'anode (8) étant reliés respectivement par des brides (2,5) au boîtier isolant (4) et fermant le boîtier (13) des deux côtés ;
(e) les puces semi-conductrices (7) sont entourées d'une plaque commune de grille (6), montée de manière isolée parallèlement au substrat (14), cette plaque de grille (6) portant les amenées pour la commande des puces semi-conductrices (7) ;
(f) le contact de cathode (1) est pourvu sur sa face interne de pistons de contact (3) pour chaque puce semi-conductrice (7) ; et
(g) les pistons de contact (3) appuient à travers des trous de passage (11) de la plaque de grille (6) sur les puces semiconductrices (7) et établissent le contact avec elles.

2. Composant selon la revendication 1, caractérisé en ce que le courant d'extinction maximum est supérieur à 1000 A et que la surface active est supérieure à 10 cm.

3. Composant selon la revendication 1, caractérisé en ce qu'au moins une partie des puces semiconductrices (7) présente respectivement la structure interne d'un composant du groupe des MCTs, des IGBTs, des GTOs, et des MOSFETs.

4. Composant selon la revendication 3, caractérisé en ce que
(a) la quantité de puces semi-conductrices (7) est subdivisée en deux parties ;
(b) l'une des deux parties comporte des puces de thyristors (7a) avec une structure interne de thyristor et l'autre des deux parties comporte des puces de diodes (7b) avec une structure interne de diode ; et
(c) à l'intérieur de la disposition de semi-conducteur (12) les puces de thyristors (7a) et les puces de diodes (7b) sont disposées alternativement côte à côte et branchées mutuellement de manière antiparallèle et constituent un thyristor à conduction inverse.

5. Composant selon la revendication 1, caractérisé en ce que
(a) le substrat (14) est un disque d'un des métaux Mo, Cu ou une combinaison Cu-Mo ;
(b) les puces semi-conductrices (7) sont soudées ou connectées par micro-câblage sur le substrat (14) ; et
(c) la plaque de grille (6) est configurée en platine de circuit, à laquelle les puces semi-conductrices (7) sont reliées par des fils de micro-câblage (9).

6. Composant selon la revendication 5, caractérisé en ce que la plaque de grille (6) porte en plus au moins un composant (15), qui est prévu pour la commande ou la protection des puces semi-conductrices (7).

7. Composant selon la revendication 1, caractérisé en ce que
(a) le contact de cathode (1) est pourvu sur sa face interne d'une multiplicité de pistons de contact supérieurs (17a) ;
(b) le contact d'anode (8) est pourvu sur sa face interne d'une multiplicité de pistons de contact inférieurs (17a) ; et
(c) chaque puce semi-conductrice est disposée respectivement entre un piston de contact supérieur (17a) et un piston de contact inférieur (17b).
